# EUROPEAN PATENT APPLICATION

(11) **EP 3 249 818 A1**
(43) Date of publication of application: **29.11.2017**
(21) Application number: 16305602.1
(22) Date of filing: 24.05.2016
(51) Int. Cl.: H03M 3/00, H03M 7/30

(54) **METHOD AND APPARATUS FOR CONVERTING AN INPUT SIGNAL TO AN OUTPUT SIGNAL**

(71) Applicant: ALCATEL LUCENT, 92100 Boulogne-Billancourt (FR)
(72) Inventor: HASLACH, Christoph, 70435 Stuttgart (DE); YU, Xin, 70435 Stuttgart (DE)
(74) Representative: Mooij, Maarten

(57) **Abstract**

The invention relates to a method for converting an input signal to an output signal. The input signal is split into a plurality of segments, each segment comprising a plurality of sample values. The segments are spread over two or more parallel stages, each of the parallel stages comprising an n-th order delta-sigma modulator, n being 1 or higher, for evaluating a respective segment of the input signal and for providing an output signal segment, wherein each delta-sigma modulator comprises n registers. The output signal segments of the two or more parallel stages are then combined to form the output signal. Additionally, n sample values for use as input to the n registers of the delta-sigma modulators of each parallel stage are determined at time instances preceding evaluation of a segment of the input signal. The determining is based on k sample values of a segment of the input signal preceding the segment to be evaluated, *k* being 1 or higher. The n sample values as determined are entered in the corresponding registers of the respective delta-sigma modulator prior to evaluation of the respective input signal segment.

## Description

### FIELD OF THE INVENTION

Embodiments of the present invention relate to a method and apparatus for converting an input signal to an output signal. Additionally, embodiments of the present invention relate to a device comprising such apparatus.

### BACKGROUND

This section introduces aspects that may be helpful in facilitating a better understanding of the invention. Accordingly, the statements of this section are to be read in this light and are not to be understood as admissions about what is known in the art.

In recent years, data-intensive content, such as streaming video, digital software distribution, online data storage or Smartphone mobile data have greatly increased the amount of data transmitted in wired and wireless communication systems. To increase the capacity of the communications systems, faster and more efficient transceivers are desired to increase the data transmission rates while improving the energy efficiency, and reducing footprint at the same time.

One approach to achieve such improved functionality is the integration of previously analog functionality into digital circuitry. Such integration allows the use of more advanced signal processing to allow for using more energy efficient hardware as well as cost saving by removing analog components. Transceivers, which comprise a transmitter module and a receiver module based on an all digital concept using switch mode amplification, may include one or more Delta-Sigma-Modulators (DSM, also ΔΣ-Modulators) for signal processing. DSMs are used to convert, or sample, an analog or digital signal with a sampling frequency, using a delta modulation, and quantize the signal into a digital signal. The difference between the analog or digital DSM input signal and the digital DSM output signal may correspond to a quantization error. Such difference may be fed back and be used to reduce the quantization error introduced by the delta modulation. Furthermore, the use of oversampling in combination with integrated feedback in delta-sigma modulation may effectively shift quantization noise to out-of-band frequencies. Subsequent filters may then remove such noise to produce a better representation of the input signal.

For digital signal to digital signal conversion a DSM may convert a digital signal with high resolution to a digital signal with low resolution. For example, the DSM may generate a coarse signal estimate using a small number of quantization levels in combination with a high sampling rate. However, for the use of a high sampling rate very fast modulators have to be fabricated. Consequently, the use of such modulators is not cost effective for many applications. It is therefore desired to enable the use of DSMs at moderate clock rates, while still achieving high performance as the DSM which is runnibg at a much higher sampling rate. This may be possible by using DSM parallelization, i.e. the use of multiple DSMs in parallel. The incoming signal is split into blocks of a certain length, and the blocks are then processed in parallel by the multiple DSMs. That is, each DSM of the multiple DSMs processes a different block of the input signal.

In an ideal, non parallelized situation, the state of the DSM, where the state relates to the one or more values present in the registers of the DSM, is depending on all preceding input signal samples. However, in order to allow parallelization, the DSM does no longer depend on all preceding input samples, as a large portion of preceding input samples are treated by other DSMs of the multiple DSMs. Consequently, there is a high risk that parallelization causes severe degradation of the signal quality. Parallelization of DSM is thus not trivial.

European patent application 1487111 describes a signal conversion method employing delta-sigma modulation for signals that comprise a "dead time", i.e. signal segments with many all-0 values or very low signal levels. In this application, multiple parallel sigma-delta modulators process input signal portions in parallel, where the cuts of the signals to form the signal portions are placed at positions within the "dead-time" segments. Cutting the signals at other positions would lead to severe distortions. If there is no dead time available, a compensation circuit is needed. The parallelization approach of European patent application 1487111 is thus only efficient if sufficient dead time is available in the input signal. Furthermore, to ensure that other types of signals can be treated as well, the addition of additional circuitry is needed, which makes the transceiver more complex and less cost effective.

Another approach, which has previously been described by the inventors of the present application, is to set the initial state of the DSM of the multiple DSMs used in a parallel setup to a default value for each block regularly after a certain number of input signal samples. The default value could be zero or a predetermined constant value. This process may be referred to as resetting the initial state of a DSM, and the default value may be referred to as reset-value. DSM-processing can now be parallelized because the reset-value is independent of preceding signal samples. However, the reset inserts distortion because the state of the DSM is no longer ideal after reset. The DSM-state resettles over time. The rate of resetting the state of the DSMs may be adopted in such a way that the resettling time is short enough compared to the time needed for a DSM state to settle. Although it is desirable to reduce the settling time further, this is a viable approach for parallelization of DSMs of lower order, i.e. a DSM comprising a single feedback loop (1^{st} order) and a single register in feed forward path (according to different implementations) or two feedback loops (2^{nd} order) and two registers in feed forward path (according to different implementations).. However, where for low order DSM the input signal can be split into relatively short segments, i.e. the time between two state resets is relatively short, for higher order DSM, i.e. a DSM comprising more registers in feed forward path as well as more feedback loops, such segments must be significantly longer, as the resettling time becomes longer for each DSM order. The longer the segments that are processed in parallel, the longer the processing delay.

### SUMMARY

The objective of embodiments of the present invention is to employ DSM parallelization with limited resettling times, which makes it particularly useful in applications using higher order DSMs. Such higher order DSMs are desirable in applications using delta-sigma modulation/pulse width modulation for switch mode systems with low resolution, e.g. a digital conversion from 16 bits resolution to 3 bits resolution. For this purpose, an embodiment of the invention relates to a method for converting an input signal to an output signal comprising: splitting the input signal into a plurality of segments, each segment comprising a plurality of sample values; spreading the segments over two or more parallel stages, each of the parallel stages comprising an n-th order delta-sigma modulator, n being 1 or higher, for evaluating a respective segment of the input signal and for providing an output signal segment, wherein each delta-sigma modulator comprises n registers; and combining the output signal segments of the two or more parallel stages to form the output signal; wherein the method further comprises: determining n sample values for use as input to the *n* registers of the delta-sigma modulators of each parallel stage at time instances preceding evaluation of a segment of the input signal, said determining being based on *k* sample values of a segment of the input signal preceding the segment to be evaluated, *k* being 1 or higher; and entering the *n* sample values as determined in the corresponding registers of the respective delta-sigma modulator prior to evaluation of the respective input signal segment.

In some embodiments, the *k* sample values of the input signal segment preceding the segment to be evaluated are the last *k* sample values of the preceding input signal segment. Since these sample values are closest to the sample values of the segment to be evaluated, a good performance may be easily obtained. To reduce the complexity of the method, while maintaining a satisfactory performance, *k* is preferably chosen to be equal to an integer in the range from 1 to 5.

In some embodiments, the method further comprises providing a calibration input signal to establish a relationship between register values of the respective delta-sigma modulators and sample values of the calibration input signal segment preceding the calibration input signal segment to be evaluated. The use of calibration may optimize the method for a specific configuration being used.

In some embodiments, n equals 2, 3 or 4. As indicated previously, in particular if higher order DSMs are used the claimed method allows for efficient employment of DSM parallelization with limited resettling times.

Evaluating may comprise at least one operation of the group of operations consisting of noise shaping and quantizing.

Embodiments of the invention further relate to a signal conversion apparatus comprising: two or more parallel stages, each of the parallel stages comprising an n-th order delta-sigma modulator, *n* being 1 or higher, wherein each delta-sigma modulator comprises n registers; a signal splitter for receiving an input signal, splitting the signal into a plurality of segments and spreading the segments over the two or more parallel stages; a signal combiner for combining output segments provided by the delta-sigma modulators of the two or more respective parallel stages after evaluation of respective input signal segments received from the signal splitter; and at least one controller communicatively coupled to the splitter and at least one delta-sigma modulator, the at least one controller being configured to: determine n sample values for use as input to the n registers of the at least one delta-sigma modulator at time instances preceding evaluation of a segment of the input signal, the determining being based on *k* sample values of a segment of the input signal preceding the segment to be evaluated, *k* being 1 or higher; and provide the n sample values as determined to the at least one delta-sigma modulator for entry in the corresponding register prior to evaluation of the respective input signal segment.

In some embodiments, the *k* sample values of the input signal segment preceding the segment to be evaluated may be the last *k* sample values of said preceding input signal segment.. Since these sample values are closest to the sample values of the segment to be evaluated, a good performance may be easily obtained. To reduce the complexity of the apparatus, while maintaining a satisfactory performance, *k* is preferably chosen to be equal to an integer in the range from 1 to 5.

In some embodiments, the controller is further configured to establish a relationship between register values of the respective delta-sigma modulators and sample values of an input signal segment preceding the input signal segment to be evaluated on the basis of a calibration input signal.. The use of calibration may optimize the method for a specific configuration of the apparatus being used.

In some embodiments, *n* equals 2, 3 or 4. As indicated previously, in particular if higher order DSMs are used the claimed method allows for efficient employment of DSM parallelization with limited resettling times.

In some embodiments, each stage further comprises a buffer communicatively coupled to an output of the splitter and to an input of the delta-sigma modulator, the buffer being configured to temporarily store at least a portion of sample values of an input signal segment. The use of a buffer enables improved control of the evaluation as the samples of an input signal segment may be provided without the risk that one or more samples are unavailable.

In some embodiments, the controller further comprises a memory for storage of the *k* sample values of the preceding signal segment.

In some embodiments, evaluation of the respective input signal segments in the delta sigma modulators in the two or more stages comprises at least one operation of the group of operations consisting of noise shaping and quantizing.

Embodiments of the invention further relate to a device comprising: an embodiment of the abovementioned apparatus, processing circuitry for processing the output signal of the apparatus to obtain a radio signal; and an antenna for transmitting the radio signal.

### BRIEF DESCRIPTION OF THE DRAWINGS

Embodiments of the present invention will now be described further, with reference to the accompanying drawings, in which
FIG. 1 schematically shows a block diagram of a signal conversion apparatus for converting an input signal to an output signal;
FIGS. 2a, 2b schematically show block diagrams of embodiments of a first order DSM;
FIG. 3 schematically shows a block diagram of a third order DSM;
FIG. 4 schematically shows a portion of controller used in an apparatus for converting an input signal to an output signal according to an embodiment of the invention;
FIG. 5 schematically shows an example of segmentation and spreading of a portion of an input signal;
FIG. 6 shows a flow diagram of a method for converting an input signal to an output signal according to an embodiment of the invention;
FIGS. 7a-7d depict exemplary calibration results for a 4^{th} order DSM;
FIGS. 8a, 8b show exemplary simulation results for a 4^{th} order DSM; and
FIG. 9 schematically shows a device according to an embodiment of the invention.

### DESCRIPTION OF THE EMBODIMENTS

The description and figures merely illustrate the principles of the invention. It will be appreciated that those skilled in the art will be able to devise various arrangements that, although not explicitly described or shown herein, embody the principles of the invention. Furthermore, all examples recited herein are principally intended expressly to aid the reader in understanding the principles of the invention and are to be construed as being without limitation to such specifically recited examples and conditions. Moreover, all statements herein reciting principles, aspects and embodiments of the invention, as well as specific examples thereof, are intended to encompass equivalents thereof.

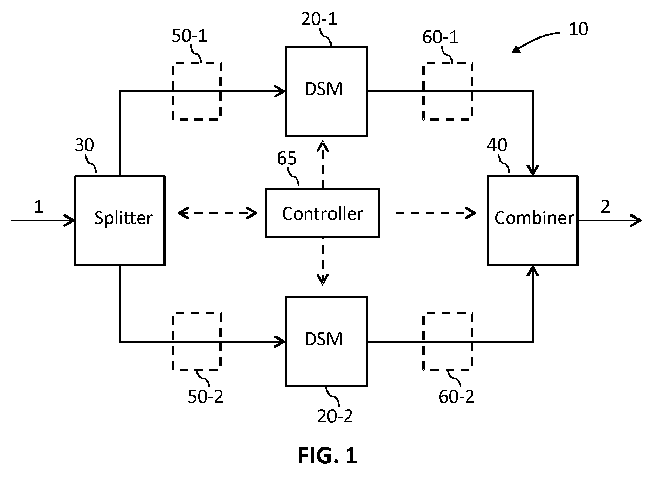

FIG. 1 schematically shows a block diagram of a signal conversion apparatus **10** for converting an input signal **1** to an output signal **2.** The apparatus **10** comprises two parallel stages ***I, II***. Each of the parallel stages ***I, II*** comprises an *n*^{th} order delta-sigma modulator (DSM), i.e. DSM **20-1** in stage ***I*** and DSM **20-2** in stage ***II*** respectively.

The apparatus **10** further comprises a signal splitter **30** for receiving the input signal **1,** splitting the received input signal **1** into a plurality of input signal segments, and spreading the input signal segments over the available stages ***I, II*.** The signal splitter **30** may take the form of a demultiplexer, in particular a demultiplexer configured for block-wise demultiplexing. The signal splitter **30** may be implemented using one or more processing units. Such one or more processing units may comprise one or more of a general purpose processor, a Digital Signal Processor (DSP), a micro-controller, a Field Programmable Gate Array (FPGA), a Programmable Logic Device (PLD), a Programmable Array Logic (PLA), etc. In some embodiments, the signal splitter **30** may be implemented using one or more Application Specific Integrated Circuits (ASIC).

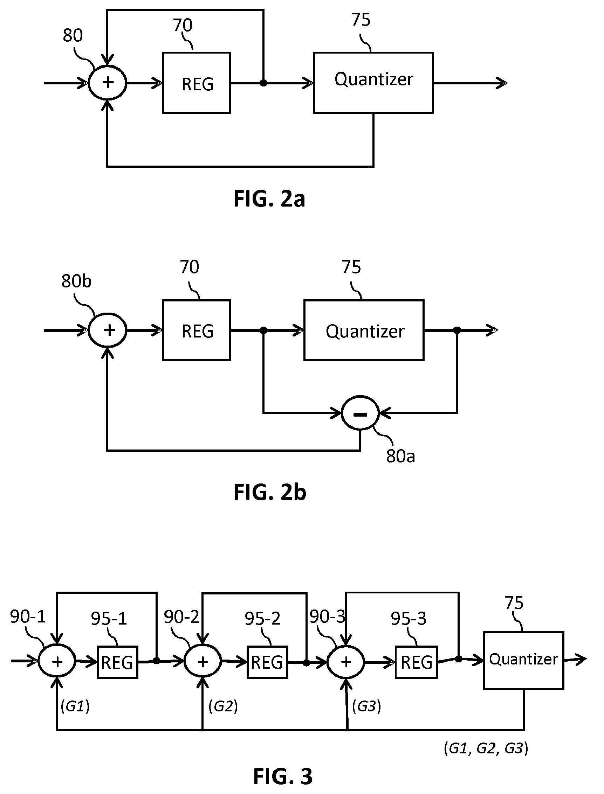

Input signal segments assigned to stage ***I*** are then processed by DSM **20-1** to form delta-sigma modulated output signal segments. Similarly, input signal segments assigned to stage ***II*** are processed by DSM **20-2** to form delta-sigma modulated output signal segments. The DSMs **20-1, 20-2** evaluate the input signal segments and form corresponding delta-sigma modulated output signal segments. In particular, the DSMs **20-1, 20-2** may convert, or sample, the input signal segments with a sampling frequency, apply delta modulation to the sampled input signal segments and quantize the result to form the digital delta-sigma modulated output signal segments. The input signal segments may be analog or digital. For digital input signal segments the DSM may execute a conversion from a digital input signal segment with high resolution to a digital output signal segment with low resolution. It will be understood that due to the parallelized setup, i.e. multiple parallel stages, each of which comprises a DSM, each DSM may operate at a reduced rate, i.e. equal to 1/*M*, where *M* corresponds to the number of parallel stages. For example, the setup shown in FIG. 1 the number of parallel stages *M*=2, and the DSMs **20-1, 20-2** may operate at half the rate as compared to a set-up using a single DSM. More details with respect to possible components and operation of delta-sigma modulators in general, and higher-order DSMs in particular will be discussed with reference to FIGS. 2 and 3 respectively.

The apparatus **10** further comprises a signal combiner **40.** The signal combiner **40** is configured to receive output signal segments provided by the delta-sigma modulators **20-1, 20-2** of the respective stages ***I, II***, and combine the received output signal segments to form the output signal **2.** The signal combiner **40** may take the form of a multiplexer, in particular a multiplexer configured for block-wise multiplexing. The signal combiner **40** may be implemented using one or more processing units. Such one or more processing units may comprise one or more of a general purpose processor, a Digital Signal Processor (DSP), a micro-controller, a Field Programmable Gate Array (FPGA), a Programmable Logic Device (PLD), a Programmable Array Logic (PLA), etc. In some embodiments, the signal combiner **40** may be implemented using one or more Application Specific Integrated Circuits (ASIC).

The DSMs **20-1, 20-2** are communicatively coupled to a controller **65.** The controller **65** is configured to control to reset the DSMs **20-1, 20-2** at predetermined time instances, as will be discussed further below. The controller **65** is configured to determine n sample values for use as input to the n registers of the DSMs **20-1, 20-2** at time instances preceding evaluation of a segment of the input signal, wherein the determining is based on *k* sample values of a segment of the input signal preceding the segment to be evaluated, *k* being an integer with a value of 1 or higher. The controller **65** is further configured to provide the *n* sample values as determined to the respective DSMs **20-1, 20-2** for entry in the corresponding register prior to evaluation of the respective input signal segment by the respective DSM **20-1, 20-2.** The controller **65** may be configured to receive information related to the split input signal. Alternatively, or additionally the controller **65** may be configured to control the (timing of) the splitting of the splitter **30.** Finally, the controller **65** may be configured to control the combiner **40.** The controller **65** is depicted as a single entity. However, it will be understood that it may comprise multiple control units, each control unit being communicatively coupled to a respective delta-sigma modulator for controlling the reset of the respective delta-sigma modulator.

In some embodiments, the apparatus **10** may further comprises input signal segment buffers **50-1, 50-2** configured to temporarily store one or more input signal segments, or a portion thereof, upstream from the respective DSMs **20-1, 20-2.** Similarly, in some embodiments, the apparatus **10** further comprises output signal segment buffers **60-1, 60-2** configured to temporarily store one or more output signal segments, or a portion thereof, downstream from the respective DSMs **20-1, 20-2.** A buffer **50-1,50-2,60-1,60-2** may comprise one or more of a fifo, a register, a flip-flop, a programmable gate, Random Access memory (RAM), non-volatile storage, and flash memory.

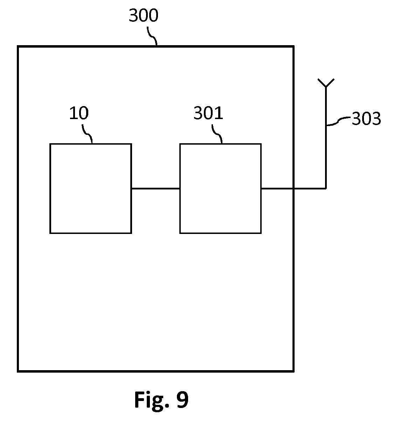

The apparatus **10** may be part of a device, for example a device **300** configured for transmitting the output signal over a radio interface as schematically depicted in FIG. 9. The device **300** may then further comprise processing circuitry **301** for processing the output signal of the apparatus to obtain a radio signal, and an antenna **303** for transmitting the radio signal. The device **300** may be a radio access node, such as a base station, or a mobile terminal, such as a user equipment.

FIGS. 2a, 2b schematically show block diagram of embodiments of a first order DSM. The first order DSM comprises a register **70** (throughout the figures abbreviated with 'REG'), a quantizer **75** and one or more adders **80.** An input signal segment sample is combined in the adder **80** with a value based on a previous input sample value obtained from the register **70** and a feedback signal value, optionally a weighted feedback signal value, received from the quantizer **75.** Typically, the (weighted) feedback signal value is negative and thus effectively results in a subtraction. In FIG. 2a, a single adder **80** is shown. Alternatively, a different number of adders may be used. For example, as depicted in FIG. 2b, a first adder **80a** may combine the register value and the feedback signal value. The output value of the first adder **80a** may then be added to a second adder **80b** to combine this output value with the input signal segment value under consideration.

The quantizer **75** may be configured to quantize the register value. A difference between the quantized register value and the original register value may be fed back and be used to reduce the quantization error introduced by the delta modulation. The feedback may be weighted, but in first order DSM the multiplication factor used for weighing the feedback signal is often chosen to equal one.

FIG. 3 schematically shows a block diagram of a third order DSM. Instead of an adder in combination with a register, the third order DSM comprises three adders **90-1, 90-2, 90-3** in combination with three corresponding registers **95-1, 95-2, 95-3.** The quantizer **75** is now coupled to the last, i.e. third register **95-3,** and provides a feedback signal to the adders **90-1, 90-2, 90-3.** The feedback signal for each adder **90-1, 90-2, 90-3** may be weighted differently by applying different weighing factors *G1*, *G2, G3* to the feedback signal value being fed to the adders **90-1, 90-2, 90-3** respectively.

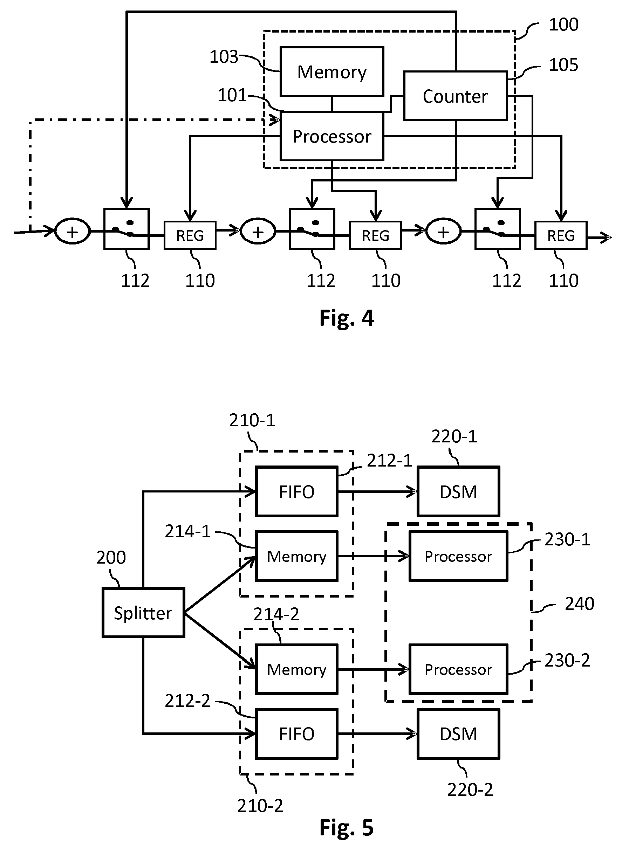

FIG. 4 schematically shows a portion **100** of controller used in an apparatus for converting an input signal to an output signal according to an embodiment of the invention. The controller portion **100** may also be referred to as a control unit **100,** and is in this exemplary embodiment configured to control reset values of registers **110** in a third order delta-sigma modulator. It will be understood that a similar controller embodiment may be used to control a delta-sigma modulator of a different order, e.g. a 1^{st} order, 2^{nd} order or 4^{th} order DSM.

The controller portion **100** comprises a processor **101** for determining the values to be input in the registers **110,** a memory **103** communicatively coupled to the processor **101** for storing values needed for the determining by the processor **101** and/or for storing reset values determined by the processor **103,** and a counter **105** for determining when a reset is needed, i.e. after a predetermined number of samples. It will be understood that instead of a counter **105** a different mechanism to determine the time at which reset values are to be input in the registers **110** may be used, for example a suitable flag may be tagged to the signal to be evaluated, e.g. at the positions at which a "reset" is to occur.

Before actual processing of an input signal segment by the DSM the processor receives *k* sample values of a segment of the input signal preceding the segment to be evaluated, *k* being an integer with a value of 1 or higher. The processor **101** then determines n values for storage in the registers **110** of the DSM. In this case *n* equals 3, since there are three registers into which a "reset" value has to be entered. Intermediate values of the calculation and/or information related to a relationship between register values of the DSM and sample values of an input signal may be stored in and/or retrieved from the memory **103,** or programmed in the processor **101.** After entering the values in the registers **110,** the DSM evaluates the input signal segment in a fashion known in the art. The input signal is monitored by the counter **105** which determines that a reset is needed after evaluation of a predetermined number of input values, the predetermined number of input values generally corresponding to the size of an input signal segment. Upon reaching the predetermined number of input values, the counter **105** triggers respective switches **112** of the DSM to establish a reset. The processor **101** in the mean time has calculated the sample values to be entered as starting sample values in the registers **110** of the DSM for the next input signal segment to be evaluated.

To ensure that the processor **101** has sufficient time to execute its determining, a buffer may be used, for example a buffer as depicted in and described with reference to FIG. 5.

Although the above describes the use of a single control unit **100** for determining the sample values to be used as starting sample values in the registers of a specific DSM, it will be understood that the same control unit **100** may be used in a similar fashion to determine such sample values for another DSM in another stage of the signal conversion apparatus.

FIG. 5 shows an example of segmentation and spreading of a portion of an input signal, for example by using a splitter **200,** which may be similar or identical to the splitter **30** of the signal converting apparatus **10** of FIG. 1. The input signal comprises a plurality of samples, i.e. in this particular example the input signal portion comprises 1024 samples taken at different times, e.g. microsecond 1 to microsecond 1024. The splitter **200** splits the input signal portion in two equally sized segments, i.e. a first input signal segment and a second signal segment, each input signal segment thus comprising 512 samples.

A first input signal segment of 512 samples is provided to a First In First Out (FIFO) element **212-1,** hereinafter referred to as fifo **212-1,** which is part of an input signal segment buffer **210-1** (e.g. similar or identical to the input signal segment buffer **50-1** in FIG. 1). The samples are then forwarded to a DSM **220-1** (e.g. similar or identical to DSM **20-1** in FIG. 1) for evaluation.

In parallel, the splitter **200** forwards a selected number of the last samples of the first input signal segment to a memory **214-2** in the input signal segment buffer **210-2.** For example, if the selected number equals 4, samples 509, 510, 511 and 512 of the input signal segment (starting with sample index 1, e.g. a sample at 1 microsecond, and ending with sample index 512, e.g. a sample at 512 microseconds) are sent to the memory **214-2.** These sample values are forwarded to a processor **230-2** (e.g. similar or identical to processor **101** in FIG. 4) of a control unit **240** (e.g. similar or identical to control unit **100** in FIG. 4) for determining register starting values for evaluating an input signal segment following the first input signal segment, i.e. the second input signal segment, as will be discussed below.

Similarly, the splitter **200** provides the second input signal segment of 512 samples is to a fifo **212-2,** which is part of an input signal segment buffer **210-2** (e.g. similar or identical to the input signal segment buffer **50-2** in FIG. 1). The samples are then forwarded to a DSM **220-2** (e.g. similar or identical to DSM **20-2** in FIG. 1) for evaluation.

In parallel, the splitter **200** forwards a selected number of the last samples of the second input signal segment to a memory **214-1** in the input signal segment buffer **210-1.** For example, if the selected number equals 4, samples 1021, 1022, 1023 and 1024 of the input signal segment (starting with sample index 513, e.g. at 513 microseconds, and ending with sample index 1024, e.g. at 1024 microseconds) are sent to the memory **214-1.** These sample values are forwarded to a processor **230-1** (e.g. similar or identical to processor **101** in FIG. 4) of a control unit **240** (e.g. similar or identical to control unit **100** in FIG. 4) for determining register starting values for evaluating an input signal segment following the first input signal segment originating from a input signal segment split in this example.

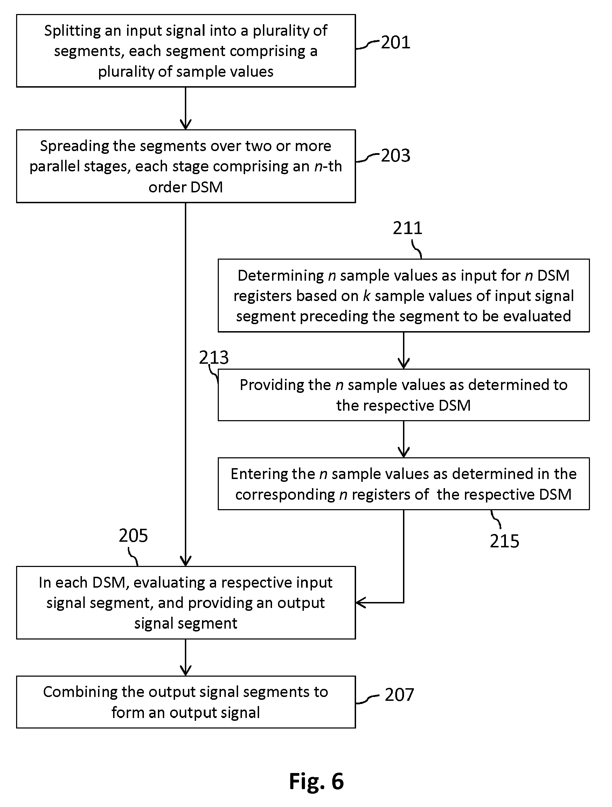

FIG. 6 shows a flow diagram of a method for converting an input signal to an output signal according to an embodiment of the invention.

First, an input signal is split into a plurality of segments, each segment comprising a plurality of sample values (action **201**). The segments are spread over two or more parallel stages, each stage comprising an n-th order DSM (action **203**).

Before evaluating the input signal segments by a DSM (action **205**), *n* sample values are determined as input for *n* DSM registers based on *k* sample values of an input signal segment preceding the segment to be evaluated (action **211**). Value *k* is an integer with a value of 1 or higher, preferably in range from 1 up to, and including, 5. The n sample values as determined are provided to the DSM (action **213**) and entered in the corresponding n registers of the DSM (action **215**).

With the n sample values being entered in the registers, the input signal segment is now evaluated by the respective DSM to provide a respective output signal segment (action **205**).

The output signal segments provided in each of the parallel stages are then combined to form an output signal (action **207**).

Due to the parallelization, the method outlined above enables the use of DSMs at moderate clock rates, while still achieving operating signal with a higher sample rate. However, degradation of the signal quality due to the fact that the register entries of the DSM do no longer depend on all preceding input samples is reduced significantly. Furthermore, the method also operates relatively well if higher order DSMs are used in the parallel stages.

Preferably, the signal conversion apparatus is calibrated before use. Calibration allows for establishing a relationship between register values of the DSMs in the parallel stages and sample values of respective input signal segments. In other words, calibration is used to define a function between register values of the DSMs in the parallel stages and sample values of respective input signal segments, the function to be used during operation to determine the n values to be entered into the respective registers as described with reference to FIG. 6.

For calibration purposes, a calibration input signal is provided, and sample values of the calibration input signal segment preceding the calibration input signal segment to be evaluated by the respective DSM are processed and entered into the register. Subsequently, operation of the DSM is monitored. By suitably varying the calibration signal segments and sample processing, abovementioned relationship can be established. The calibration signal may correspond to a known test signal, e.g. a signal with an LTE test pattern. In some embodiments, different calibration signals may be used, e.g. signals with different bandwidth, sampling, etc.

The calibration may be made in a simulation environment. The registers of a DSM are then monitored and compared with the input signal samples. The register entries are manipulated using one or more input samples of a calibration input signal segment preceding the calibration input signal segment under evaluation, which may also be referred to as one or more input samples. For a 4^{th} order DSM, four registers are thus to be monitored. Comparing the register entries with various time shifts of the input signal sequence will select that version of the input signal for each register that provides the highest correlation between input sequence and register sequence.

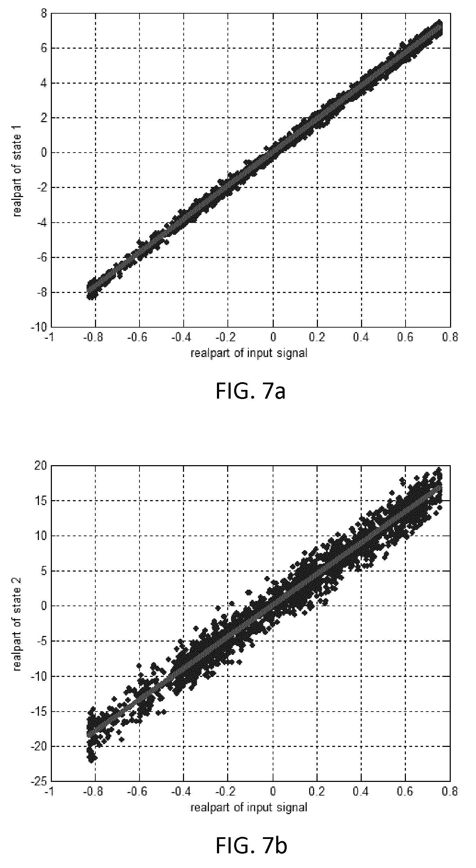

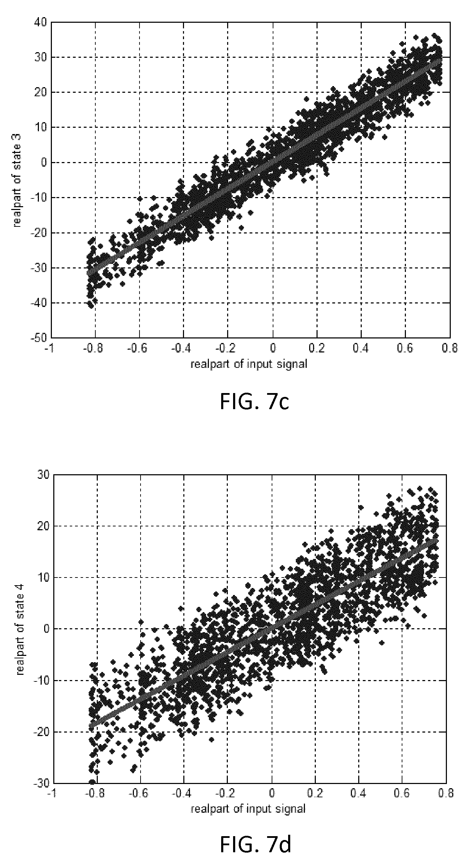

FIGS. 7a-7d depict exemplary calibration results for a DSM having four registers. In FIGS. 7a-7d, the real part of the register entries are compared with the real part of the input signal samples. FIG. 7a depicts the relationship for the first register of the 4^{th} order DSM, while FIGS. 7b, 7c, 7d depict the relationship for the second, third and fourth register of the 4^{th} order DSM respectively. Although in this example the input signal sample values, as well as the register entry values, were complex values, visual illustration is highly simplified by merely depicting the real parts of these values. Nevertheless, in practical applications, it is preferable to perform a calibration analysis, including comparison and correlation, using complex valued numbers. The lines in FIGS. 7a-7d indicate that the register entries can be predicted by a linear mapping of input samples to register entries.

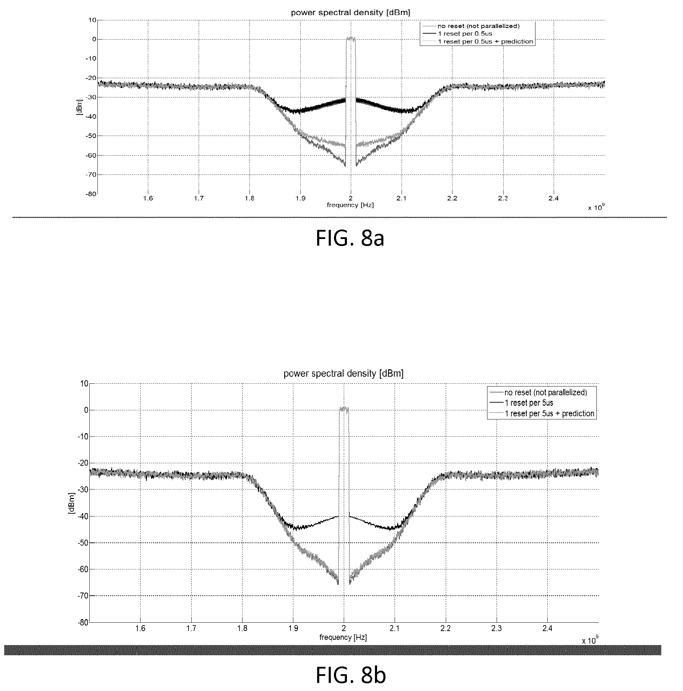

FIGS. 8a and 8b show simulation results for a 4^{th} order DSM for an LTE signal at a 2 GHz carrier frequency. In the simulation depicted in FIG. 8a, with respect to the method presented in this application 1 reset per 0.5 microseconds was executed, while FIG. 8b depicts the simulation results for 1 reset per 5 microseconds. In FIG. 8a, it can be seen that the method presented in this application (middle curve) improves the performance significantly as compared to a similar reset in which all registers are set to zero (upper curve). The lower curve in FIG: 8a shows simulation results for evaluation without a reset. In FIG. 8b, the performance of the method presented in this application is nearly the same as can be achieved without a reset.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A method for converting an input signal to an output signal comprising:
- splitting the input signal into a plurality of segments, each segment comprising a plurality of sample values;
- spreading the segments over two or more parallel stages, each of the parallel stages comprising an n-th order delta-sigma modulator, n being 1 or higher, for evaluating a respective segment of the input signal and for providing an output signal segment, wherein each delta-sigma modulator comprises n registers; and
- combining the output signal segments of the two or more parallel stages to form the output signal;
wherein the method further comprises:
- determining n sample values for use as input to the n registers of the delta-sigma modulators of each parallel stage at time instances preceding evaluation of a segment of the input signal, said determining being based on k sample values of a segment of the input signal preceding the segment to be evaluated, *k* being 1 or higher; and
- entering the n sample values as determined in the corresponding registers of the respective delta-sigma modulator prior to evaluation of the respective input signal segment.

2. The method according to claim 1, wherein the k sample values of the input signal segment preceding the segment to be evaluated are the last *k* sample values of said preceding input signal segment.

3. The method according to claim 2, wherein k is equal to an integer in the range from 1 to 5.

4. The method according to any one of the preceding claims, further comprises providing a calibration input signal to establish a relationship between register values of the respective delta-sigma modulators and sample values of the calibration input signal segment preceding the calibration input signal segment to be evaluated.

5. The method according to any one of the preceding claims, wherein n equals 2, 3 or 4.

6. The method according to any one of the preceding claims, wherein evaluating comprises at least one operation of the group of operations consisting of noise shaping and quantizing.

7. A signal conversion apparatus (10) comprising:
- two or more parallel stages, each of the parallel stages comprising an n-th order delta-sigma modulator, n being 1 or higher, wherein each delta-sigma modulator comprises n registers;
- a signal splitter for receiving an input signal, splitting the signal into a plurality of segments and spreading the segments over the two or more parallel stages;
- a signal combiner for combining output segments provided by the delta-sigma modulators of the two or more respective parallel stages after evaluation of respective input signal segments received from the signal splitter; and
- at least one controller communicatively coupled to the splitter and at least one delta-sigma modulator, the at least one controller being configured to:
- determine n sample values for use as input to the n registers of the at least one delta-sigma modulator at time instances preceding evaluation of a segment of the input signal, the determining being based on k sample values of a segment of the input signal preceding the segment to be evaluated, *k* being 1 or higher; and
- provide the n sample values as determined to the at least one delta-sigma modulator for entry in the corresponding register prior to evaluation of the respective input signal segment.

8. The apparatus according to claim 7, wherein the k sample values of the input signal segment preceding the segment to be evaluated are the last *k* sample values of said preceding input signal segment.

9. The apparatus according to claim 8, wherein k is equal to an integer in the range from 1 to 5.

10. The apparatus according to any one of claims 7-9, wherein the controller is further configured to establish a relationship between register values of the respective delta-sigma modulators and sample values of an input signal segment preceding the input signal segment to be evaluated on the basis of a calibration input signal.

11. The apparatus according to any one of claims 7-9, wherein n equals 2, 3 or 4.

12. The apparatus according to any one of claims 7-11, wherein each stage further comprises a buffer communicatively coupled to an output of the splitter and to an input of the delta-sigma modulator, the buffer being configured to temporarily store at least a portion of sample values of an input signal segment.

13. The apparatus according to any one of claims 7-12, wherein the controller further comprises a memory for storage of the k sample values of the preceding signal segment.

14. The apparatus according to any one of claims 7-13, wherein evaluation of the respective input signal segments in the delta sigma modulators in the two or more stages comprises at least one operation of the group of operations consisting of noise shaping and quantizing.

15. Device (300) comprising:
- the apparatus (10) according to any one of claims 7-14: and
- processing circuitry (301) for processing the output signal of the apparatus to obtain a radio signal ; and
- an antenna (303) for transmitting the radio signal.
